Europäisches Patentamt

European Patent Office

Office européen des brevets

(19)

(11) Veröffentlichungsnummer: **0 206 087**
**B1**

(12) # EUROPÄISCHE PATENTSCHRIFT

(45) Veröffentlichungstag der Patentschrift:
20.09.89

(51) Int. Cl.⁴: **H03K 17/18, H03K 17/08**

(21) Anmeldenummer: **86107862.4**

(22) Anmeldetag: **09.06.86**

(54) Verfahren und Vorrichtung zur Erkennung des Sperrzustandes eines abschaltbaren Thyristors.

(30) Priorität: **19.06.85 DE 3521920**
**17.10.85 DE 3537050**

(43) Veröffentlichungstag der Anmeldung:
**30.12.86 Patentblatt 86/52**

(45) Bekanntmachung des Hinweises auf die Patenterteilung:
**20.09.89 Patentblatt 89/38**

(84) Benannte Vertragsstaaten:
**AT CH DE FR GB IT LI NL SE**

(56) Entgegenhaltungen:
**EP-A- 0 032 552**
**EP-A- 0 112 007**
**EP-A- 0 141 624**
**EP-A- 0 176 800**
**DE-A- 2 744 693**
**DE-A- 2 830 662**

(73) Patentinhaber: **Siemens Aktiengesellschaft,**
**Wittelsbacherplatz 2, D-8000 München 2(DE)**

(72) Erfinder: **Peppel, Michael, Dr.,**
**Albert-Schweitzer-Strasse 6a, D-8525 Uttenreuth(DE)**
Erfinder: **Salzmann, Theodor, Dipl.-Ing.,**
**Leimbergerstrasse 29, D-8520 Erlangen(DE)**

## Beschreibung

Verfahren zur Erkennung des Sperrzustandes eines abschaltbaren Thyristors (GTO-Thyristor), insbesondere auch nach einem vergeblichen Abschaltversuch bei durchlegiertem Thyristor, indem nach Auftreten eines Abschaltsignales ein den Eintritt des Sperrzustandes kennzeichnendes Zustandssignal aus der zeitlichen Ableitung des Gatestromes gebildet wird.

Ein solches Verfahren findet bevorzugt Anwendung in Stromrichterschaltungen mit GTO-Thyristoren, z.B. in Brückenanordnungen, bei denen während der Stromkommutierung von einer Brückenzweighälfte auf die andere die gegenseitige Ablösung der Thyristoren bei der Stromführung zeitoptimal erfolgen soll. Dabei müssen zur Verhinderung eines Kurzschlusses Pausenzeiten zwischen den einzelnen Thyristoreinschaltsignalen eingehalten werden, damit auch für eine kurze Übergangszeit niemals beide Thyristoren eines Brückenzweiges gleichzeitig stromleitend sind. Diese Pausenzeiten sind aber nicht nur abhängig vom jeweiligen Thyristorbetriebszustand, gekennzeichnet durch seine aktuelle Sperrschichttemperatur, Vorwärtssperrspannung und Durchlaßstrom, sondern auch von seinen zusätzlichen Beschaltungen, die für einen sicheren Betrieb notwendig sind und bevorzugt zur Schaltentlastung dienen. Der Wert der minimal zulässigen Pausenzeit ergibt sich dabei grundsätzlich aus dem ungünstigsten Betriebspunkt mit maximaler Thyristorlöschzeit, unter Umständen bei Beachtung eines eigenen Zeitverhaltens der zusätzlichen Schaltentlastungsvorrichtungen. Damit ist aber ein insgesamt zeitunoptimales Betriebsverhalten des Stromrichters verbunden. Bei Anwendung des erfindungsgemäßen Verfahrens reduzieren sich dagegen diese Pausenzeiten durch eine adaptive, gegenseitige Verriegelung der Thyristoreinschaltsignale auf den minimalen Wert, der für den jeweiligen Betriebszustand der Thyristoren und deren Beschaltungen notwendig ist. Die Ablösung in der Stromführung kann nun zeitoptimal erfolgen, da der Moment des Eintritts des sperrenden Schaltzustandes des abzulösenden Thyristors tatsächlich erkannt wird, und nicht mittels einer sogenannten Worst-Case-Betrachtung abgeschätzt werden muß.

Insbesondere auch im Fehlerfalle bei Eintritt der dauernden Leitfähigkeit zwischen der Anode und Kathode des GTO-Thyristors aufgrund einer Durchlegierung der Halbleiterschichten können durch Anwendung des erfindungsgemäßen Verfahrens bei Ausbleiben des den Sperrzustand kennzeichnenden Zustandsignales rechtzeitig Schutzmaßnahmen eingeleitet werden. Neben dem Auslösen von Störungsmeldungen ist es hierbei insbesondere wichtig, z.B. möglichst schnell das Einschaltsignal für einen weiteren noch intakten Thyristor im Zweig einer Brückenschaltung zur Verhinderung eines Kurzschlusses zu unterdrükken.

In der deutschen Patentanmeldung mit dem amtlichen Aktenzeichen P 34 34 607.4 sind für den Betrieb von GTO-Thyristoren bereits drei Verfahren zur Erkennung des stromsperrenden Schaltzustandes beschrieben.

So wird nach Auftreten eines Abschaltbefehles im ersten der vorgeschlagenen Verfahren die negative Spannung zwischen dem Gate und der Kathode des Thyristors erfaßt und ein den Eintritt des Sperrzustandes kennzeichnendes Zustandssignal gebildet, wenn die Gate-Kathodenspannung eine negative Schwelle unterschreitet.

Ein weiteres Verfahren erfaßt statt der Gate-Kathoden-Spannung am Thyristor den beim Abschaltvorgang in seinen Gate-Anschluß fließenden negativen Steuerstrom und bildet das den Eintritt des Sperrzustandes kennzeichnende Zustandssignal, wenn die zeitliche Ableitung des steuernden Gate-Stromes nach Auftreten eines Abschaltbefehles ihr Vorzeichen wechselt.

In einem dritten Verfahren wird unter weiterer Ausbildung des zweiten Verfahrens das Zustandssignal gebildet, wenn entweder die zeitliche Ableitung des Gate-Stromes ihr Vorzeichen gewechselt und der Gate-Strom selbst eine negative Schwelle unterschritten hat, oder die zeitliche Ableitung des Gate-Stromes zwar das Vorzeichen gewechselt, aber innerhalb einer vorgegebenen Zeitdauer der Gate-Strom die negative Schwelle nicht unterschritten hat.

Dabei kann anhand des internen Verhaltens des Steuerkreises beim Abschaltvorgang, z.B. mit Hilfe eines durch den negativen Steuerstrom am Ausgang der Ansteuereinheit, im folgenden Treiber genannt, hervorgerufenen Spannungsabfalles, bedingt durch eine von Null verschiedene Ausgangsimpedanz, auf den momentan fließenden Gate-Strom und dessen zeitliche Ableitung zurückgeschlossen werden, um damit den aktuellen Schaltzustand, insbesondere den Sperrzustand, zu erkennen.

Die notwendige Minimierung des eigentlich unerwünschten Spannungsabfalles am Ausgang des Treibers bedingt aber insgesamt einen relativ geringen Signal-Störabstand bei den auszuwertenden Signalen. Zudem können Schwankungen in der Amplitude des stark von der Größe des aktuellen Anoden-Kathodenstromes des Thyristors abhängigen negativen Gate-Stromes zu einer weiteren Reduzierung des ohnehin geringen Spannungsabfalles führen. Diese Umstände können in manchen Fällen, z.B. wenn sich nach einem Abschaltbefehl der Sperrzustand tatsächlich nicht einstellt, die rechtzeitige Erkennung eines thyristorinternen Dauerkurzschlusses aufgrund Durchlegierung der Halbleiterschichten erschweren.

Der Erfindung liegt folglich die Aufgabe zugrunde, auf andere, und besonders einfache und zuverlässige Art und Weise den Eintritt des stromsperrenden Schaltzustandes zu erkennen. Insbesondere soll auch bei einem Defekt des GTO-Thyristors sicher erkannt werden können, daß eine dauernde Leitfähigkeit zwischen Anode und Kathode vorliegt, und demzufolge der vorangegangene Abschaltversuch nicht erfolgreich abgelaufen ist. Schließlich soll auch bei einer Fehlfunktion des Treibers, der den Thyristor zwischen seiner Gate-Kathodenstrecke ansteuert, der tatsächlich vorliegende Schaltzustand des Thyristors richtig angezeigt werden. Dies ist insbesondere dann wichtig, wenn der

Thyristor wegen eines Treiberdefektes einen anstehenden Abschaltbefehl nicht ausführen kann.

Die Aufgabe wird nach Auftreten eines Abschaltbefehles mit einem aus der zeitlichen Ableitung des Gate-Stromes gebildeten und den Eintritt des Sperrzustandes kennzeichnenden Zustandsignales dadurch gelöst, daß das Zustandssignal dann ausgelöst wird, wenn die zeitliche Ableitung des Gate-Stromes ihr Vorzeichen umkehrt und einen vorgegebenen positiven Grenzwert überschreitet, der größer gewählt wird als der beim Abschaltversuch eines durchlegierten GTO-Thyristors auftretende maximale positive Wert der zeitlichen Ableitung des Gate-Stromes.

In weiterer Ausgestaltung der Erfindung entsteht mit Auftreten eines Abschaltsignales am Ausgang eines Treibers, der an der Gate- und Kathodenelektrode des Thyristors angeschlossen ist, eine negative Schaltspannung, welche die Abschaltung des Thyristors einleitet, und es ist dabei von besonderem Vorteil, daß der Vorgang der Bildung des Zustandssignales dann freigegeben wird, wenn diese Schaltspannung eine geeignet gewählte untere Schwelle unterschritten hat. Bevorzugt wird die untere Schwelle mit Berücksichtigung treiberinterner, parasitärer Induktivitäten so gewählt, daß diese bei ordnungsgemäßer Funktion des Treibers im Moment des Auftretens des Abschaltsignales von der negativen Schaltspannung sicher unterschritten wird.

In weiterer Ausgestaltung der Erfindung ist es vorteilhaft, daß kein Zustandssignal ausgelöst wird, solange eine mit Beginn des Vorganges der Zustandssignalbildung gestartete, einstellbare Ablaufzeit noch nicht beendet ist und/oder nachdem die zeitliche Ableitung des Gate-Stromes zu Beginn der Abschaltung einen vorgegebenen negativen Grenzwert unterschritten hat. Dabei werden der vorgebbare Grenzwert und die einstellbare Ablaufzeit so aufeinander abgestimmt, daß die zeitliche Ableitung des Gate-Stromes den negativen Grenzwert unterschritten hat, bevor die Ablaufzeit beendet ist.

Ferner ist es insgesamt für die Erhöhung der Störfestigkeit von besonderem Vorteil, wenn zur Verhinderung von Fehlauslösungen des Zustandssignales die Auswirkung von impulsartigen Störungen des Gate-Stromes ausgefiltert wird, und/oder wenn gleichzeitig mit Ende des Thyristorabschaltsignales die Bildung des Zustandssignales gesperrt wird.

Eine geeignete und bevorzugt angewendete Vorrichtung zur Bildung des den Sperrzustand kennzeichnenden Zustandssignales besteht aus einem differenzierenden Meßgeber, der die zeitliche Ableitung des Gate-Stromes bildet, und aus einem Schmitt-Trigger mit vorgebbarem positiven und negativen Schaltgrenzwert, der aus der zeitlichen Ableitung des Gate-Stromes ein binäres Signal ableitet, welches über ein logisches UND-Glied mit einem Hilfssignal zum Zustandssignal verknüpft wird, wobei ein Signalgeber das Hilfssignal direkt aus dem Thyristor-Abschaltsignal einschaltverzögert über eine einstellbare Ablaufzeit bildet.

Eine weitere, besonders geeignete Vorrichtung zur Bildung des den Sperrzustand kennzeichnenden Zustandssignales besteht aus einem Treiber, der vom Abschaltsignal angesteuert wird und den Thyristor zwischen dessen Gate- und Kathodenelektrode mit einer negativen Schaltspannung versorgt, und aus einem differenzierenden Meßgeber, der die zeitliche Ableitung des Gate-Stromes bildet, und aus einem Schmitt-Trigger mit vorgebbarem positiven und negativen Schaltgrenzwert, der aus der zeitlichen Ableitung des Gate-Stromes ein binäres Signal ableitet, und aus einem Signalgeber, der ein Hilfssignal einschaltverzögert über eine einstellbare Ablaufzeit erzeugt, welche vom invertierenden Ausgang eines Komparators angestoßen wird, der die Schaltspannung am Ausgang des Treibers auf eine einstellbare untere Schwelle überwacht, und schließlich aus einem logischen UND-Glied, welches das binäre Signal und das Hilfssignal zum Zustandssignal verknüpft.

Es ist von besonderem Vorteil, wenn zusätzelich ein Zeitverzögerungsglied als Filterelement vorüberrgehende Änderungen des binären Signales unterdrückt, die durch impulsartige Störungen des Gate-Stromes hervorgerufen wer den und die kürzer sind als eine über das Zeitverzögerungsglied vorgebbare Filterzeit, wodurch Fehlauslösungen des Zustandssignales verhindert werden. Bevorzugt werden auch Mittel zur Sperrung des Zustandssignales am Ende des Thyristor-Abschaltsignales durch Inaktivierung des Schmitt-Trigger-Einganges eingesetzt.

Besonders geeignet zur Verwendung als differenzierender Meßgeber ist eine Koppelinduktivität, die vom Magnetfeld einer vom Gate-Strom durchflossenen Primärwicklung durchsetzt ist, und die bevorzugt als eine zweidimensionale Struktur auf einer Leiterplatte ausgeführt ist.

Mit den nachstehend angeführten Abbildungen wird die Erfindung im Folgenden näher erläutert. Dabei zeigt:

Fig. 1 allgemein die Verläufe von elektrischen Zustandsgrößen und die Bildung des Zustandssignales bei erfolgreicher Abschaltung eines GTO-Thyristors, für zwei unterschiedlich hohe Anoden-Kathoden-Ströme.

Fig. 2 allgemein die Verläufe von elektrischen Zustandsgrößen bei einem erfolglosen Abschaltversuch eines defekten GTO-Thyristors,

Fig. 3 das Blockschaltbild einer bevorzugten Vorrichtung zur Durchführung des erfindungsgemäßen Verfahrens,

Fig. 4 speziell die Verläufe von elektrischen Zustandsgrößen und Signalen bei erfolgreicher Abschaltung mit anschließender Wiedereinschaltung eines GTO-Thyristors unter Anwendung des erfindungsgemäßen Verfahrens,

Fig. 5 speziell die Verläufe von elektrischen Zustandsgrößen und Signalen bei einem erfolglosen Abschaltversuch eines defekten GTO-Thyristors unter Anwendung des erfindungsgemäßen Verfahrens,

Fig. 6 ein geeignetes Ausführungsbeispiel der bevorzugten Vorrichtung,

Fig. 7 das Blockschaltbild einer weiteren bevorzugten Vorrichtung zur Durchführung des erfindungsgemäßen Verfahrens, und

Fig. 8 ein geeignetes Ausführungsbeispiel der weiteren bevorzugten Vorrichtung.

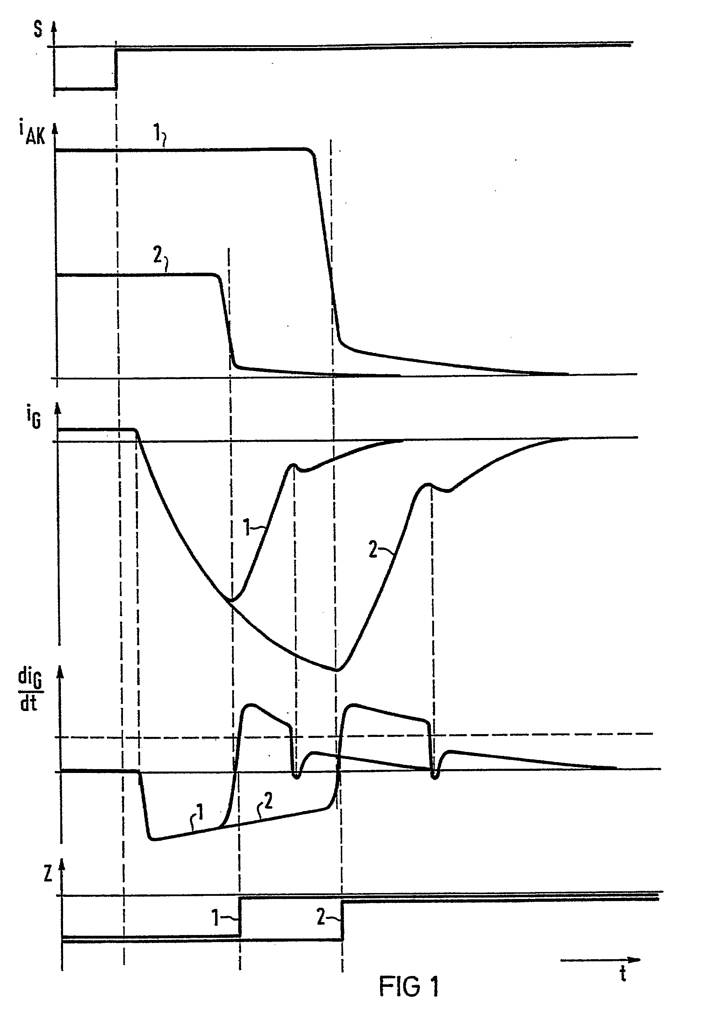

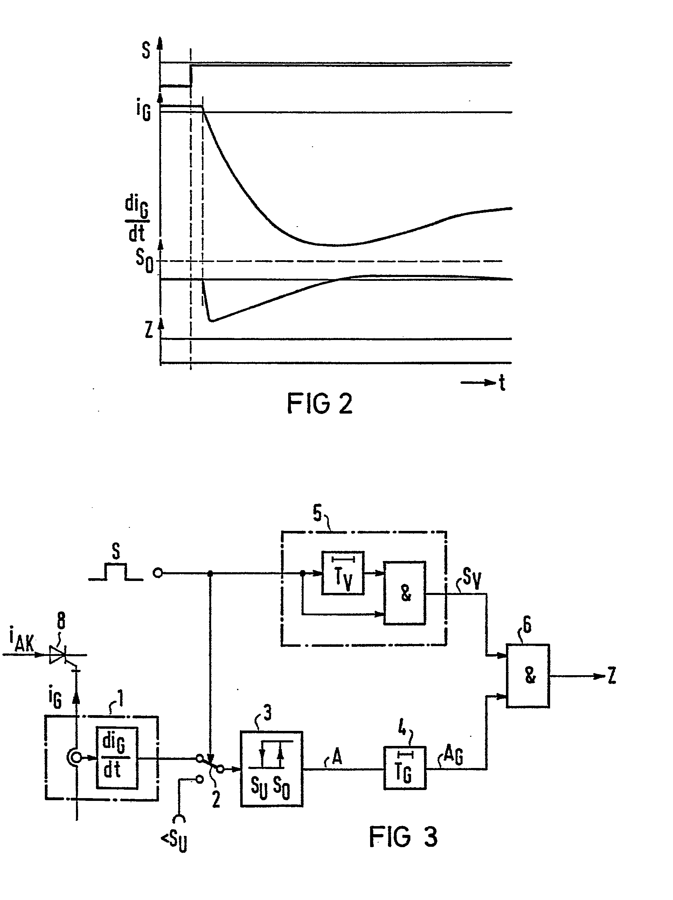

In den Figuren 1 bzw. 2 sind bei Vorliegen eines Abschaltsignales S jeweils die Verläufe des Gate-Stromes $i_G$ und dessen zeitlicher Ableitung für einen intakten bzw. defekten GTO-Thyristor gegenübergestellt.

Dabei zeigt Fig. 1 diese Signale gleichzeitig für das Abschalten von zwei unterschiedlich hohen Anoden-Kathodenströmen $i_{AK}$ in Form zweier Kurvenscharen, die mit den Zahlen 1 bzw. 2 markiert sind. Man erkennt, daß die Maximalwerte der zeitlichen Ableitung des Gate-Stromes beim Abschalten eines intakten GTO-Thyristors relativ unabhängig vom aktuellen Wert des jeweils abzuschaltenden Anoden-Kathodenstromes sind. So ist die steil ansteigende Flanke des Gate-Stromes nach Überschreiten seines negativen Minimums im allgemeinen ein sicheres Zeichen für den tatsächlichen Eintritt des stromsperrenden Schaltzustandes, bzw. das Ausbleiben dieser Flanke ein sicheres Zeichen für eine Durchlegierung der Halbleiterschichten.

Während in Fig. 1 also die Abschaltung ordnungsgemäß abläuft und das Zustandssignal Z im Bereich des wiederansteigenden, in Richtung auf den Wert Null abklingenden, negativen Gate-Stromes nach Überschreiten seines absoluten Minimums dann gebildet wird, nachdem seine zeitliche Ableitung eine positive Schwelle $S_O$ überschritten hat, bleibt in Fig. 2 die Abschaltung erfolglos. Der Gate-Strom schwingt dort auf einen stationären, negativen Wert ein, wobei das Minimum bei weitem nicht so stark ausgeprägt ist wie bei intaktem Thyristor und der darauf folgende Anstieg bis hin zum stationären Dauerstrom relativ langsam erfolgt.

Wird nun insbesondere die positive Schwelle $S_O$ für die zeitliche Ableitung des Gatestromes größer gewählt als die maximal beim Abschaltversuch eines durchlegierten GTO-Thyristors gemäß Fig. 2 auftretende zeitliche Änderung des Gate-Stromes, so läßt sich aus einem, bei Überschreiten dieser Schwelle abgeleiteten Zustandssignal Z der tatsächliche Eintritt des Sperrzustandes bzw. dessen Ausbleiben erkennen.

Der Vorteil des erfindungsgemäßen Verfahrens liegt darin, daß zur einfachen und betriebssicheren Erkennung des GTO-Sperrzustandes allein die Auswertung der zeitlichen Ableitung des Gate-Stromes ausreicht. Da das Verfahren unabhängig von der Größe des aktuell zu löschenden Ventilstromes ist, ergibt sich eine arbeitspunktunabhängige, gleichmäßig hohe Störfestigkeit. Ferner ist es mit geringem Aufwand in eine Vorrichtung umzusetzen.

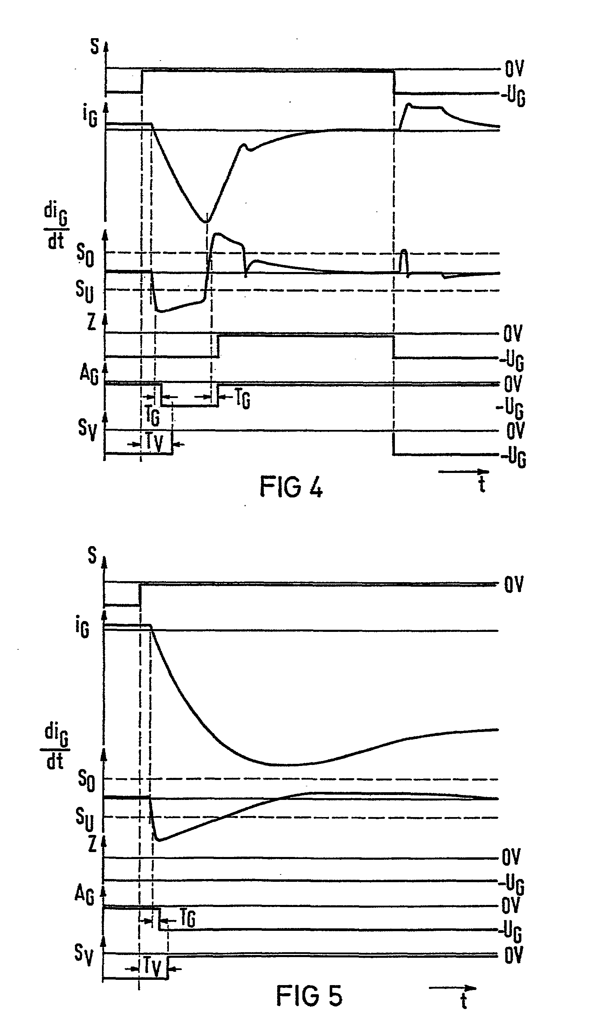

Fig. 3 stellt als Blockschaltbild eine bevorzugt angewendete Vorrichtung zur Bildung des Zustandssignales Z dar. In den beiden folgenden Figuren sind die bei der Thyristorabschaltung wichtigen elektrischen Zustandsgrößen und alle weiteren dazugehörigen Zwischensignale, in Fig. 4 für den Fall einer erfolgreichen Thyristorabschaltung mit anschließender Wiedereinschaltung, bzw. entsprechend in Fig. 5 für eine vergebliche Abschaltung dargestellt.

Ein differenzierender Meßgeber 1 bildet gemäß Fig. 3 die zeitliche Ableitung des Gate-Stromes. Diese wird über ein schaltendes Element 2, das bei Vorliegen eines aktiven Abschaltsignales S geschlossen ist, an den Eingang eines Schmitt-Triggers 3 mit je einem vorgebbaren positiven und negativen Schaltgrenzwert $S_O$ und $S_U$ angelegt, und in ein binäres Signal A umgewandelt. Ein Zeitverzögerungsglied 4 mit je einer identischen Ein- und Ausschaltverzögerungszeit $T_G$ überführt dieses Signal in das Signal $A_G$ und bildet über ein logisches UND-Glied 6 mit einem Hilfssignal $S_V$ verknüpft das eigentliche Zustandssignal Z. Dabei dient das Zeitverzögerungsglied 4 als eine Art Filterelement mit vorgebbarer Filterzeit $T_G$. Mögliche, impulsartige Störungen des Gate-Stromes $i_G$, die sich insbesondere in seiner zeitlichen Ableitung bemerkbar machen und dazu führen, daß der Schmitt-Trigger 3 vorübergehend den logischen Zustand seines Ausgangssignales A verändert, werden nicht an das Signal $A_G$ weitergegeben, wenn vor Ablauf der Zeit $T_G$ sich der ursprüngliche Zustand des Ausgangssignales A wieder eingestellt hat. Es werden somit Fehlauslösungen des Zustandssignales Z vermieden.

Dem gleichen Zweck dient das schaltende Element 2, indem es die Bildung des Zustandssignales Z durch Inaktivierung des Schmitt-Trigger-Einganges dann sperrt, wenn wegen Fehlen eines Thyristor-Abschaltsignales S ein aktives Zustandssignal Z grundsätzlich nicht sinnvoll ist.

Selbst nach Auftreten eines Abschaltsignales S wird die Bildung des Zustandssignales Z für eine einstellbare Zeit $T_V$ über die UND-Verknüpfung 6 mit dem über die Einschaltverzögerung 5 aus dem Abschaltsignal S selbst abgeleiteten Hilfssignal $S_V$ gesperrt. Eine Bildung des Zustandssignales Z wird folglich erst dann ermöglicht, wenn nach Vorliegen des Abschaltsignales S der Abschaltvorgang voll in Gang gekommen und der Eintritt des stromsperrenden Schaltzustandes wahrscheinlich geworden ist.

In der folgenden Figur 4 wird dies weiter verdeutlicht, wobei neben dem Gate-Strom $i_G$ und dessen zeitlicher Ableitung auch das um $T_V$ verzögerte Hilfssignal $S_V$, das gefilterte Schmitt-Trigger-Ausgangssignal $A_G$ und das Zustandssignal Z dargestellt sind für den Fall einer erfolgreichen GTO-Abschaltung mit anschließender Wiedereinschaltung. Dabei weist am rechten Bildrand die Bezeichnungen - $U_G$ auf den logisch inaktiven, bzw. OV auf den logisch aktiven Signalpegel des jeweiligen Signales hin.

Nach Eintritt eines Abschaltsignales S ist die Bildung des Zustandssignales Z frühestens nach Ablauf der einstellbaren Verzugszeit $T_V$ mit der steigenden Flanke des Hilfssignales $S_V$ möglich. Nun ist der Abschaltvorgang in vollem Gange und der Gate-Strom nähert sich mit stark fallender Flanke seinem absoluten Minimum. Zuvor wurde der Schmitt-Trigger mit Unterschreiten der negativen Schaltschwelle $S_U$ durch die zeitliche Ableitung des Gate-Stromes in den logisch inaktiven Zustand geschaltet, was aus Fig. 4 durch die fallende Flanke des um $T_G$ verzögerten Sigales $A_G$ zu entnehmen ist. Die einstellbare Ablaufzeit $T_V$ und der vorgebbare, negative Schaltgrenzwert $S_U$ müssen dabei so aufeinander abgestimmt sein, daß kein aktives Zustandssignal Z unzulässigerweise kurzzeitig dadurch ausgelöst wird, daß die Ablaufzeit bereits beendet ist bevor die zeitliche Ableitung des Gate-Stromes die negative Schaltschwelle $S_U$ unterschritten hat.

Ein sicheres Zeichen für eine erfolgreich ablaufende Abschaltung ist, wie bereits ausgeführt, der steile Wiederanstieg des Gate-Stromes nach seinem negativen Minimum bis hin zum Wert Null. Eine solche große Steigung tritt nur bei intaktem GTO-Thyristor auf und kennzeichnet in etwa den Eintritt des stromsperrenden Schaltzustandes. Dementsprechend wird nach dem Nulldurchgang das anschliessende Überschreiten der oberen Schwelle $S_O$ durch die zeitliche Ableitung des Gate-Stromes $i_G$ zur Bildung des Zustandssignales Z ausgenutzt, zumal der steile Wiederanstieg des Gate-Stromes relativ unabhängig von der Größe des aktuell zu löschenden Ventilstromes $i_{AK}$ ist.

Da dieser steile Wiederanstieg bei durchlegiertem Thyristor ausbleibt, wie aus Fig. 5 zu ersehen, und der Gate-Strom $i_G$ nur allmählich auf einen stationären, negativen Wert einschwingt, überschreitet in diesem Fall die zeitliche Änderung des Gate-Stromes die obere Schwelle $S_O$ nicht und das Zustandssignal wird nicht ausgelöst.

Vorteilhaft wird mit Auftreten eines Abschaltsignales zusätzlich eine weitere Ablaufzeit angestoßen, die so groß gewählt wird, daß vor ihrer Beendigung ein intakter Thyristor sicher abgeschaltet ist. Damit kann das Ausbleiben des Zustandssignales überwacht werden, und mit Beendigung der Ablaufzeit z.B. Störungsmeldesignale ausgelöst und insbesondere Schutzmaßnahmen eingeleitet werden.

Das erfindungsgemäße Verfahren bleibt auch dann funktionsfähig, wenn beim Abschalten eines sehr niedrigen Anoden-Kathodenstromes $i_{AK}$, wie dies z.B. im Leerlauf einer Stromrichterschaltung der Fall ist, kein auswertbarer Gate-Strom $i_G$ mehr zur Verfügung steht. Da dieser keine der beiden Grenzen $S_U$ bzw. $S_O$ unter- bzw. überschreitet, bleibt in diesem Fall das Ausgangssignal $A_G$ des Schmitt-Triggers immer aktiv. Das Zustandssignal Z wird nun hilfsweise gleichzeitig mit der ansteigenden Flanke des Hilfssignales $S_V$ gebildet. Der Zeitpunkt des Eintritts des stromsperrenden Schaltzustandes des Thyristors liegt zwar vor dem Aktivwerden von $S_V$ und kann nun nicht mehr exakt erkannt werden. Ein solches Verhalten ist im Leerlauffalle jedoch voll ausreichend.

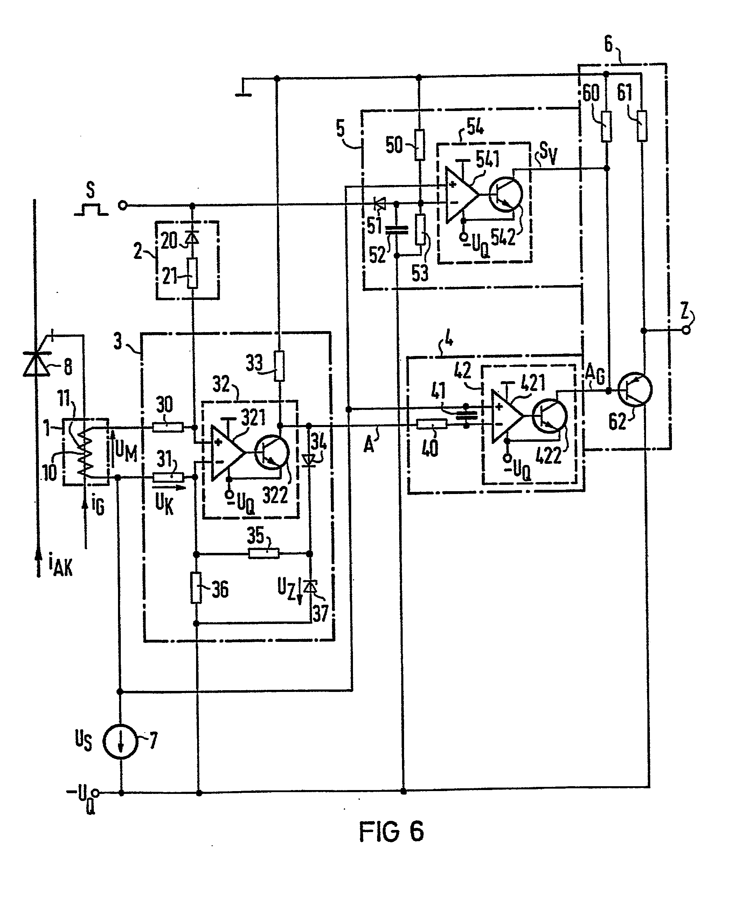

Fig. 6 zeigt ein geeignetes Ausführungsbeispiel zur bevorzugten Vorrichtung nach Blockschaltbild Fig. 3, wobei auch hier ein Signal mit einem Spannungspegel nahe dem Wert Null als aktiv und ein Signal mit einem Spannungspegel nahe einer negativen Versorgungsspannung $U_Q$ als inaktiv betrachtet werden soll.

Besonders vorteilhaft wird dabei im differenzierenden Meßgeber 1 die zeitliche Ableitung des Gate-Stromes auf induktive Weise über eine Koppelinduktivität 11 erfaßt, die über eine Primärwicklung 10 vom Magnetfeld des Gate-Stromes $i_G$ durchsetzt ist, und in eine Hilfsspannung $U_M$ abgebildet. Diese ist unabhängig von den Potentialverhältnissen am GTO-Thyristor selbst.

Ein praktischer Aufbau dieser Koppelinduktivität kann dabei auf äußerst einfache Weise erfolgen, z.B. in Form einer zweidimensionalen Struktur als "gedruckte Spule" auf einer Leiterplatte. Solche Anordnungen sind bereits aus der Hochfrequenztechnik bekannt. Bei einem dreidimensionalen Aufbau als gewickelte Spule sind insbesondere an den Spulenkörper keinerlei Anforderungen zu stellen.

Der wesentliche Teil des sich an den differenzierenden Meßgeber 1 anschließenden Schmitt-Triggers 3 besteht aus einem Operationsverstärker 321 mit einem sich in Emitterschaltung anschließenden Schalttransistor 322, mit Kollektor-Pull-Up-Widerstand 33, als Komparator 32. Er ist über die beiden Vorschaltwiderstände 30 und 31, jeweils vor seinem invertierenden bzw. nicht invertierendem Eingang, an den Meßgeber 1 angeschlossen, wobei der Widerstand 31 zusätzlich mit dem positiven Potential einer mit ihrem negativen Potential an die negative Versorgungsspannung $U_Q$ angeschlossenen Hilfsspannungsquelle $U_S$ verbunden ist.

Zur Erzeugung der Schalthysterese des Schmitt-Triggers, gekennzeichnet durch die beiden Schaltgrenzwerte $S_O$ und $S_U$, ist der Komparator 32 von seinem Ausgang, dem Kollektor des Schalttransistors 322, zum invertierenden Eingang des Operationsverstärkers 321 rückgekoppelt über eine Diode 34. Diese ist in Reihe angeordnet mit einem Spannungsteiler aus den Widerständen 35 und 36 mit antiparalleler Zenerdiode 37, welche gemeinsam mit dem Widerstand 36 an der negativen Versorgungsspannung $U_Q$ angeschlossen ist. Der invertierende Eingang ist dabei zwischen den Widerständen 35 und 36 mit dieser Rückkoppelung verbunden.

Insbesondere werden der positive und negative Schaltgrenzwert $S_U$ und $S_O$ des Schmitt-Triggers durch einen, vom jeweiligen Schaltzustand des Komparators abhängigen Spannungsabfall $U_K$ über dem Vorschaltwiderstand 31 bestimmt. Dieser ergibt sich aus der Differenz des um die Hilfsspannung $U_S$ vergrößerten konstanten Potentials der Versorgungsspannung $U_Q$ und des aktuellen Potentials am invertierenden Eingang des Operationsverstärkers 321.

Dieses Potential wird mit Vorliegen der negativen Schaltschwelle $S_U$ bei nichtgeschaltetem Transistor 322, wobei das Signal A am Transistorkollektor einen aktiven Zustand mit näherungsweise Nullpotential besitzt, bestimmt durch die Teilung der um die Knickspannung $U_Z$ der Zenerdiode 37 erhöhten Versorgungsspannung $U_Q$ an den Widerständen 35 und 36. Die Schwellspannung $U_K$ ist in diesem Fall im Vergleich zu der in Fig. 6 eingezeichneten Zählrichtung negativ.

Mit Vorliegen der positiven Schaltschwelle $S_U$ bei geschaltetem Transistor 322, wobei das Signal A einen nichtaktiven Zustand mit einem Potential nahe dem Wert der negativen Versorgungsspannung $U_Q$ hat, ist auch das Potential am invertierenden Operationsverstärkereingang annähernd identisch dem Wert der Versorgungsspannung $U_Q$. Die Rückkopplungsschaltung ist in diesem Fall unwirksam und es stellt sich eine positive Schwellspannung $U_K$ ein.

Der Komparator 32 kippt z.B. bei bisher nicht aktivem Ausgangssignal A mit Vorliegen des positiven Schaltgrenzwertes $S_O$ nur dann in den aktiven Schaltzustand, sobald zwischen nichtinvertierendem und invertierendem Eingang des Operationsverstärkers eine positive Differenzsspannung anliegt. Eine von einem zunehmenden Gate-strom hervorgerufene positive Hilfsspannung $U_M$ muß dabei das Potential am nichtinvertierendem Eingang, welches im Ruhezustand dem um $U_S$ erhöhten Wert der negativen Versorgungsspannung $U_Q$ entspricht, soweit anheben, daß es grösser ist als das Potential am invertierenden Eingang, welches sich aus dem um die positive Schaltspannung $U_K$ erniedrigten und um $U_S$ erhöhten Potential der Versorgungsspannung $U_Q$ ergibt. Umgekehrt muß bei bisher aktivem Ausgangssignal A mit Vorliegen des negativen Schaltgrenzwertes $S_O$ eine negative Hilfsspannung $U_M$ das Potential am nichtinvertierendem Eingang entgegen der negativen Schaltspannung $U_K$ soweit absenken, daß sich eine negative Differenzspannung ergibt, um den Komparator zu kippen.

Dem Komparator ist es grundsätzlich nur dann möglich Schaltvorgänge auszuführen, wenn Mittel zur Sperrung des Zustandssignales unwirksam sind. Diese sind in Fig. 3 als Schalter 2 dargestellt und in Fig. 6 als eine den nichtinvertierenden Operationsverstärkereingang mit dem Thyristor-Abschaltsignal S verbindende Reihenschaltung aus einer Diode 20 und einem Widerstand 21 ausgeführt. So ist bei Vorliegen eines aktiven Thyristor-Abschaltsignales S die Diode 20 gesperrt und der nichtinvertierende Eingang des Operationsverstärker 321 bleibt somit unbeeinflußt. Bei nichtaktiven Abschaltsignal S dagegen liegt wegen leitender Diode 20 ein so großes negatives Potential am nichtinvertierenden Eingang an, daß ein Hilfssignal $U_M$ der üblichen Größe die Potentialverhältnisse nicht bis zum Überschreiten der Schaltgrenzwerte verändern kann. Ferner wird durch das negative Potential am nichtinvertierenden Eingang und durch die sich daraus ergebende negative Differenzspannung immer der aktive Zustand des Signales A erzwungen, was einem Rücksetzen des Schmitt-Triggers 3 entspricht.

Das Schmitt-Trigger-Ausgangssignal A wird durch das als Filterelement dienende Zeitverzögerungsglied 4 in das geglättete Signal $A_G$ umgewandelt. Die Filterzeit $T_G$ ist dabei gegeben durch die Lade-/Entladezeitkonstante eines zwischen dem invertierenden und nichtinvertierenden Eingang eines Komparators 42 liegenden RC-Gliedes, bestehend aus dem Widerstand 40 und dem Kondensator 41. Der Komparator 42 ist dabei in bekannter Weise aus einem mit einem Schalttransistor in Emitterschaltung abgeschlossenen Operationsverstärker 421 ausgeführt. Der für die Schaltfunktion am Thyristor-Kollektor notwendige sogenannte Pull-Up-Widerstand 60 ist dabei in dem folgenden UND-Glied 6 mit enthalten, das in sogenannter Wired-AND-Schaltungstechnik ausgeführt ist, und zum Ansteuern der Basis eines Schalttransistors 62 mit Emitter-Widerstand 61 dient. Das den stromsperrenden Schaltzustand des GTO-Thyristors anzeigende Zustandssignal Z steht am Ausgang des UND-Gliedes, dem Emitter des Schalttransistors 63, an. Der Widerstand 60 dient dabei gleichzeitig als Pull-Up-Widerstand für den am Ausgang des Signalgebers 5 im Komparator 54 vorhandenen Schalttransistors 542.

Der Signalgeber 5 bildet das Signal $S_V$ einschaltverzögert über eine einstellbare Ablaufzeit $T_V$ unmittelbar aus dem Thyristor-Abschaltsignal S. Er besteht aus einem in bekannter Weise mit einem Schalttransistor 542 abgeschlossenen Operationsverstärker 541 als Komparator 54, dessen invertierender Eingang über eine in Sperrichtung angeordnete Diode 51 vom Abschaltsignal S angesteuert wird, und über einen Widerstand 50 mit dem Nullpotential und über eine Parallelschaltung aus einem Kondensator 52 und einem Widerstand 53 mit der negativen Versorgungsspannung $U_Q$ verbunden ist. Dabei wird die einstellbare Ablaufzeit $T_V$ bei Vorliegen eines Abschaltsignales S bestimmt durch die Ladezeitkonstante eines RC-Gliedes, bestehend aus dem Kondensator 52 und den Widerständen 50 und 53. Bei Verschwinden des Thyristorabschaltsignales S dagegen wird durch kurzschlußartiges Entladen des Kondensators 52 über die Diode 51 der Komparator 54 beinahe verzögerungsfrei das Signal $S_V$ in den inaktiven Zustand geschaltet.

Das Zustandssignal Z wird schließlich durch logische UND-Verknüpfung des geglätteten Schmitt-Triggersignals $A_G$ mit dem einschaltverzögerten Abschaltsignal $S_V$ am Emitter des Schalttransistors (62) dadurch gebildet, daß die Kollektoren der beiden Schalttransistoren 422 und 542 gemeinsam am Widerstand 60 angeschlossen sind und damit den Transistor 62 zwischen dessen Basis und Emitter ansteuern.

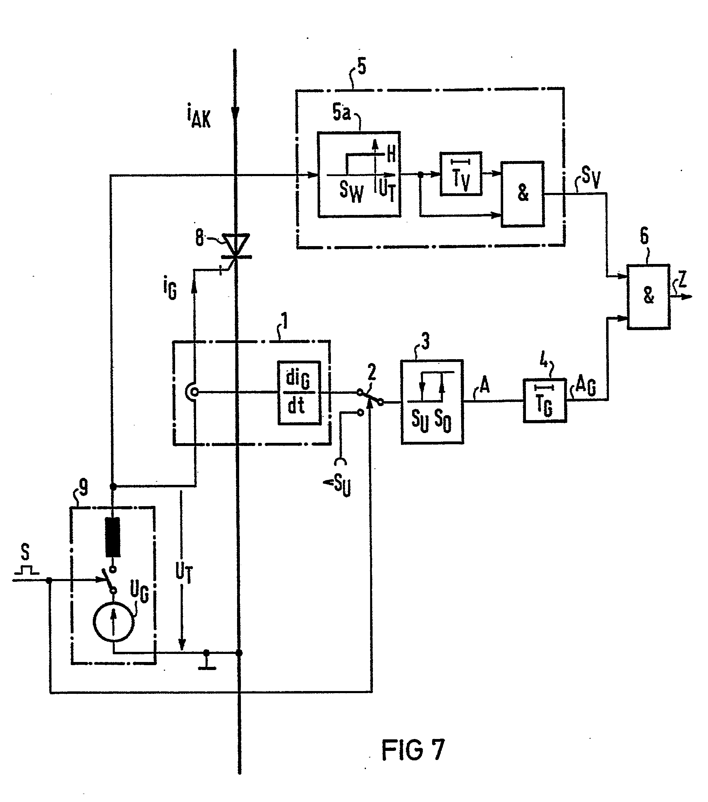

Figur 7 stellt als Blockschaltbild eine weitere geeignete Vorrichtung zur Bildung des Zustandssignales Z dar. Sie ist eine bevorzugt angewendete Weiterbildung der Anordnung von Figur 3. Dabei ist zusätzlich ein Treiber 9 vorhanden, welcher mit der an seinem Ausgang auftretenden Schaltspannung $U_T$ die Ein- bzw. Ausschaltung des Thyristors 8 über dessen Gate-Kathodenstrecke bewirkt. Zur näherungsweisen Darstellung seines zur Ausschaltung des Thyristors notwendigen elektrischen Verhaltens ist in Figur 7 in dessen Inneren eine Reihenschaltung aus einer Konstantspannungsquelle $U_G$, einem idealen Schalter und einer Induktivität dargestellt. Die konkrete Induktivität hat dabei die Funktion eines Ersatzbauelementes, welches treiberinterne, parasitäre Induktivitäten berücksichtigt.

Bei Auftreten eines Abschaltsignales S wird der Schalter im Ersatzschaltbild des Treibers 9 geschlossen. Die Konstantspannung $U_G$ bestimmt den stationären Endwert der zur Thyristorabschaltung dienenden negativen Schaltspannung $U_T$. Im Moment des Auftretens des Abschaltbefehles wird zwar die Schaltspannung $U_T$ wegen der parasitären Induktivitäten, die von dem sich langsam aufbauenden negativen Gate-Strom $i_G$ durchsetzt werden, ihren Maximalwert noch nicht erreicht haben. Dennoch wird in diesem Augenblick bei geeigneter Dimensionierung eine untere Schwelle $S_W$ in einem die Schaltspannung $U_T$ überwachenden, zusätzlichen Komparator 5a unterschritten. Hierdurch wird entsprechend dem erfindungsgemäßen Verfahren die Bildung des den Sperrzustand anzeigenden Zustandssignales Z freigegeben, indem als Beginn dieses Vorganges das inverse Komparatorausgangssignal die bekannte Ablaufzeit $T_V$ anstößt.

In dem bekannten Ausführungsbeispiel der Figur 3 wird die Zustandssignalbildung bereits bei Auftreten eines "Ausschaltbefehles" S freigegeben, ohne daß festgestellt werden kann, ob der ebenfalls von diesem Signal angesteuerte Treiber 9 die zur Abschaltung notwendige Schaltspannung $U_T$ tatsächlich an den Thyristor angelegt hat. Die weitere Ausbildung des erfindungsgemäßen Verfahrens gemäß Figur 7 hat dagegen als besonderen Vorteil, daß der tatsächliche Schaltzustand des Thyristors 8 auch bei einem Defekt des Treibers 9 richtig wiedergegeben wird. So ist eine Überwachung der ordnungsgemäßen Funktion des Treibers im Zustandssignal Z mit enthalten. Durch gleichzeitige Auswertung des Abschaltsignales S, des invertierten Ausgangssignales des Komparators 5a und des Zustandssignales Z ist leicht zu erkennen, ob die Ursache für das Ausbleiben eines aktiven Zustandssignales in einem Defekt des Treibers oder des GTO-Thyristors zu suchen ist. Ferner ist diese Art der Zustandserkennung nicht nur von der ordnungsgemäßen Funktion des Treibers unabhängig, sondern auch von dessen spezifischer interner Schaltungsstruktur. Abgesehen von einer eventuellen Nachstimmung der Größe des Schwellwertes $S_W$ kann sie mit jeder beliebigen Treiberstruktur durchgeführt werden.

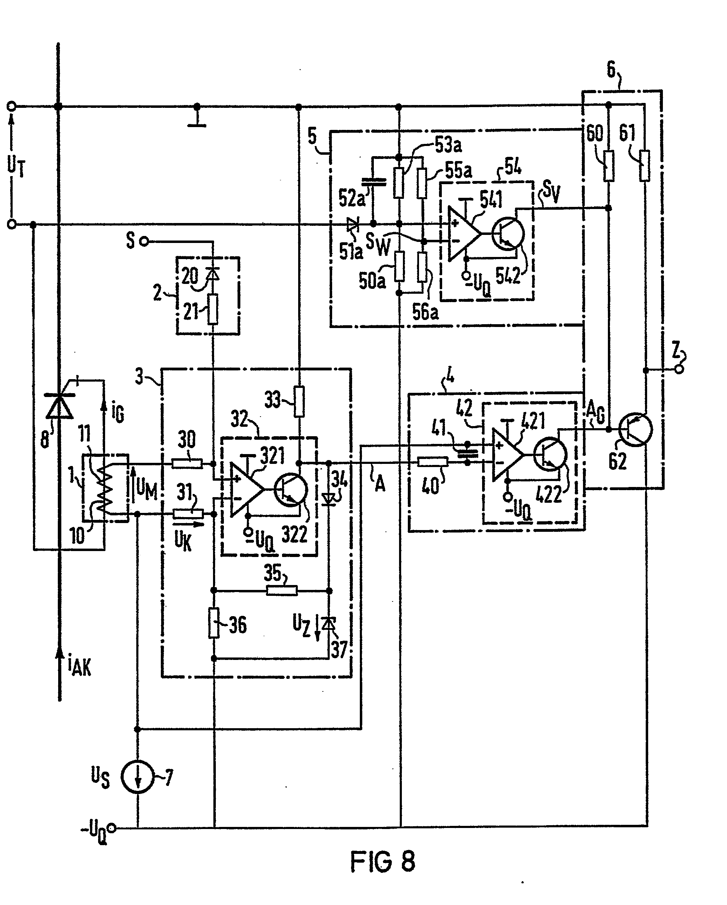

Figure 8 zeigt schließlich die zur Berücksichtigung der erfindungsgemäßen Weiterbildung des Verfahrens gemäß Figur 7 notwendigen Modifikationen des Ausführungsbeispieles der Figur 6. Die vom Treiber kommende Schaltspannung $U_T$, welche auf das Potential der Thyristorkathode bezogen wird, ist im Falle einer Thyristorabschaltung negativ und wird im Signalgeber 5 auf die untere Schwelle $S_W$ überwacht. Deren Wert wird bestimmt durch die Größe der beiden Widerstände 55a und 56a, die als Spannungsteiler am invertierenden Eingang des Komparators 54 angeschlossen sind. Die Einschaltverzögerung mit der Zeit $T_V$ wird analog der in Figur 6 dargestellten Vorrichtung durch die Diode 51a, den Kondensator 52a und die beiden Widerständen 53a und 50a am nichtinvertierenden Eingang des Komparators 54 gebildet. Dabei bestimmt die Ladezeitkonstante des RC-Gliedes, bestehend aus den Elementen 52a, 53a und 50a den Wert der Ablaufzeit $T_V$. Ebenfalls wird der Kondensator 52a in bekannter Weise durch die Diode 51a bei Verschwinden des Abschaltsignales, also bei positiver Schaltspannung $U_T$ kurzschlußartig entladen, wodurch das Signal $S_V$ beinahe verzögerungsfrei in den inaktiven Zustand geschaltet wird.

Mit dem erfindungsgemäßen Verfahren wird auf einfache und betriebssichere Weise der Eintritt des stromsperrenden Schaltzustandes eines GTO-Thyristors nach Auftreten eines Abschaltbefehles, aber auch dessen Ausbleiben bei einem vergeblichen Abschaltversuch wegen Durchlegierung der Halbleiterschichten bzw. bei Defekt im Treiber sicher erkannt, so daß das Folgezünden benachbarter Thyristoren in Stromrichtereinheiten durch eine adaptive, gegenseitige Verriegelung zeitoptimal erfolgen kann, bzw. bei einem der oben genannten Defekte rechtzeitig Schutzmaßnahmen für die restliche Schaltung eingeleitet werden können.

## Patentansprüche

1. Verfahren zur Erkennung des Sperrzustandes eines abschaltbaren Thyristors (GTO-Thyristor) (8), insbesondere auch nach einem vergeblichen Abschaltversuch bei durchlegiertem Thyristor, in dem nach Auftreten eines Abschaltsignales (S) ein den Eintritt des Sperrzustandes kennzeichnendes Zustandssignal (Z) aus der zeitlichen Ableitung des Gate-Stromes ($di_G/dt$) gebildet wird, dadurch gekennzeichnet, daß das Zustandssignal dann ausgelöst wird, wenn die zeitliche Ableitung des Gate-Stromes ihr Vorzeichen umkehrt und einen vorgegebenen positiven Grenzwert ($S_O$) überschreitet, der größer gewählt wird als der beim Abschaltversuch eines durchlegierten GTO-Thyristors auftretende maximale positive Wert der zeitlichen Ableitung des Gate-Stromes.

2. Verfahren nach Anspruch 1, dadurch gekennzeichnet, daß mit Auftreten eines Abschaltsignales (S) am Ausgang eines Treibers (9), der an der Gate- und Kathodenelektrode des Thyristors (8) angeschlossen ist, eine negative Schaltspannung ($U_T$) entsteht, welche die Abschaltung des Thyristors einleitet, und daß der Vorgang der Bildung des Zustandssignales (Z) dann freigegeben wird, wenn diese Schaltspannung ($U_T$) eine geeignet gewählte untere Schwelle ($S_W$) unterschritten hat.

3. Verfahren nach Anspruch 2, dadurch gekennzeichnet, daß mit Berücksichtigung treiberinterner, parasitärer Induktivitäten die untere Schwelle ($S_W$) so gewählt wird, daß diese bei ordnungsgemäßer Funktion des Treibers (9) im Moment des Auftretens des Abschaltsignales (S) von der negativen Schaltspannung ($U_T$) sicher unterschritten wird.

4. Verfahren nach einem der vorangegangenen Ansprüche, dadurch gekennzeichnet, daß kein Zustandssignal (Z) ausgelöst wird, solange eine mit Beginn des Vorganges der Zustandssignalbildung gestartete, ein-

stellbare Ablaufzeit ($T_V$) noch nicht beendet ist und/oder nachdem die zeitliche Ableitung des Gate-Stromes zu Beginn der Abschaltung einen vorgegebenen negativen Grenzwert ($S_U$) unterschritten hat.

5. Verfahren nach Anspruch 4,
dadurch gekennzeichnet, daß der vorgebbare negative Grenzwert ($S_U$) und die einstellbare Ablaufzeit ($T_V$) so aufeinander abgestimmt werden, daß die zeitliche Ableitung des Gate-Stromes den negativen Grenzwert unterschritten hat, bevor die Ablaufzeit beendet ist.

6. Verfahren nach einem der vorangegegangenen Ansprüche, .
dadurch gekennzeichnet, daß zur Verhinderung von Fehlauslösungen des Zustandssignales die Auswirkung von impulsartigen Störungen des Gate-Stromes ($i_G$) ausgefiltert wird.

7. Verfahren nach einem der vorangegangenen Ansprüche,
dadurch gekennzeichnet, daß gleichzeitig mit Ende des Thyristor-Abschaltsignales (S) die Bildung des Zustandssignales (Z) gesperrt wird.

8. Vorrichtung zur Bildung des den Sperrzustand kennzeichnenden Zustandssignales (Z) nach dem Verfahren einer der Ansprüche 1 oder 4 bis 7,
gekennzeichnet durch
a) einen differenzierenden meßgeber (1), der die zeitliche Ableitung des Gate-Stromes ($i_G$) bildet,
b) einen Schmitt-Trigger (3) mit vorgebbarem positiven und negativen Schaltgrenzwert ($S_O$, $S_U$), der aus der zeitlichen Ableitung des Gate-Stromes eine binares Signal (A) ableitet,
c) einen Signalgeber (5), der ein Hilfssignal ($S_V$) direkt aus dem Thyristor-Abschaltsignal (S) einschaltverzögert über eine einstellbare Ablaufzeit ($T_V$) bildet, und
d) ein logisches UND-Glied (6), welches das binäre Signal (A) und das Hilfssignal ($S_V$) zum Zustandssignal (Z) verknüpft.

9. Vorrichtung zur Bildung des den Sperrzustand kennzeichnenden Zustandssignales (Z) nach dem Verfahren einer der Ansprüche 1 bis 7,
gekennzeichnet durch
a) einen Treiber (9), der vom Abschaltsignal (S) angesteuert wird und den Thyristor (8) zwischen dessen Gate- und Kathodenelektrode mit einer negativen Schaltspannung ($U_T$) versorgt,
b) einen differenzierenden Meßgeber (1), der die zeitliche Ableitung des Gate-Stromes ($I_G$) bildet,
c) einen Schmitt-Trigger (3) mit vorgebbarem positiven und negativen Schaltgrenzwert ($S_O$, $S_U$), der aus der zeitlichen Ableitung des Gate-Stromes ein binäres Signal (A) ableitet,
d) einen Signalgeber (5), der ein Hilfssignal ($S_V$) einschaltverzögert über eine einstellbare Ablaufzeit ($T_V$) erzeugt, welche vom invertierenden Ausgang eines Komparators (5a) angestoßen wird, der die Schaltspannung ($U_T$) am Ausgang des Treibers (9) auf eine einstellbare untere Schwelle ($S_W$) überwacht, und
e) ein logisches UND-Glied (6), welches das binäre Signal (A) und das Hilfssignal ($S_V$) zum Zustandssignal (Z) verknüpft.

10. Vorrichtung nach einem der Ansprüche 8 oder 9,
gekennzeichnet durch
ein Zeitverzögerungsglied (4) als Filterelement, welches vorübergehende Änderungen des binären Signales (A) unterdrückt, die durch impulsartige Störungen des Gate-Stromes hervorgerufen werden und die kürzer sind als eine über das Zeitverzögerungsglied vorgebbare Filterzeit ($T_G$), wodurch Fehlauslösungen des Zustandssignales verhindert werden.

11. Vorrichtung nach einem der ANsprüche 8 oder 9,
gekennzeichnet durch
Mittel (2) zur Sperrung des Zustandssignales am Ende des Thyristor-Abschaltsignales (S) durch Inaktivierung des Schmitt-Trigger-Einganges.

12. Vorrichtung nach einem der Ansprüche 8 oder 9,
gekennzeichnet durch
eine Koppelinduktivität (11) als differenzierenden Meßgeber (1), die vom Magnetfeld einer vom Gate-Strom ($i_G$) durchflossenen Primärwicklung (10) durchsetzt ist.

13. Vorrichtung nach Anspruch 12,
dadurch gekennzeichnet, daß die Koppelinduktivität als eine zweidimensionale Struktur auf einer Leiterplatte ausgeführt ist.

**Claims**

1. A process for detecting the blocking state of a gate turn-off thyristor (GTO thyristor) (8), in particular also after an unsuccessful attempt at disconnection in the case of a failed thyristor, in which after the occurrence of a disconnection signal (S) a state signal (Z) characterising entry into the blocking state is formed from the time derivative of the gate current ($di_G/dt$), characterised in that the state signal is given when the time derivative of the gate current change; its sign and exceeds a predetermined positive limiting value ($S_O$) which is chosen to be larger than the maximum positive value of the time derivative of the gate current occurring during the attempt to disconnect a failed GTO thyristor.

2. A process according to claim 1, characterized in that the occurrence of a disconnection signal (S) at the output of a driver (9) which is connected to the gate and cathode electrodes of the thyristor (8), results in a negative switching voltage ($U_T$) which initiates the disconnection of the thyristor, and that the process for forming the state signal (Z) is triggered when this switching voltage ($U_T$) has fallen below a suitably chosen lower threshold ($S_W$).

3. A process according to claim 2, characterised in that the lower threshold ($S_W$) is selected, having regard to internal parasitic inductances of the driver so that with the driver (9) functioning properly at the moment the blocking signal (S) occurs the negative switching voltage ($U_T$) reliably falls below this threshold.

4. A process according to any one of the preceding claims, characterised in that no state signal (Z) is initiated as long as an adjustable operating time

(Tᵥ) started at the beginning of the process of forming the state signal has not yet ended and/or after the time derivative of the gate current at the beginning of the disconnection has fallen below a predetermined negative limiting value (S_U).

5. A process according to claim 4, characterized in that the predeterminable negative limiting value (S_U) and the adjustable operating time (T_V) are coordinated so that the time derivative of the gate current has fallen below the negative limiting value before the operating time has ended.

6. A process according to any one of the preceding claims, characterised in that in order to prevent false tripping of the state signal the effect of the pulsed disturbances of the gate current (i_G) is filtered out.

7. A process according to any one of the preceding claims, characterised in that the formation of the state signal (Z) is blocked simultaneously with the end of the thyristor disconnection signal (S).

8. A device for forming the state signal (Z) characterising the blocking state according to the process of any one of claims 1 or 4 to 7, characterized by:

a) a differentiating encoder (1), which generates the time derivative of the gate current (i_G),

b) a Schmitt trigger (3) with predeterminable positive and negative switching limiting values (S_O, S_U) which derives a binary signal (A) from the time derivative of the gate current,

c) a transducer (5) which forms an auxiliary signal (S_V) directly from the thyristor disconnection signal (3), time-delayed over an adjustable operating time (T_V), and

d) a logic AND-element (6) which combines the binary signal (A) and the auxiliary signal (S_V) to form the state signal (Z).

9. A device for forming the state signal (Z) characterising the blocking state according to the process of any one of claims 1 to 7, characterised by:

a) a driver (9) which is controlled by the disconnection signal (S) and supplies the thyristor (8) between its gate and cathode electrodes with a negative switching voltage (U_T).

b) a differentiating encoder (1) which forms the time derivative of the gate current (i_G),

c) a Schmitt trigger (3) having a predeterminable positive and negative switching limiting values (S_O, S_U) which derives a binary signal (A) from the time derivative of the gate current (i_G),

d) a transducer (5) which produces an auxiliary signal (S_V) switching delayed over an adjustable functioning time (T_V) which is triggered from the inverting output of a comparator (5a) which monitors the switching voltage (U_T) at the output of the driver (9) to an adjustable lower threshold value (S_W), and

e) a logic AND-element (6) which combines the binary signal (A) and the auxiliary signal (S_V) to form the state signal (Z).

10. A device according claim 8 or claim 9, characterized by a time delay element (4) as filter element which suppresses temporary changes in the binary signal (A) which are caused by pulsed disturbances in the gate current and which are shorter than a filter period (T_G) which can be determined by the time delay element, whereby false tripping of the state signal can be prevented.

11. A device according to claim 8 or claim 9, characterised by means (2) to block the state signal at the end of the thyristor disconnecting signal (S) by inactivating the Schmitt trigger input.

12. A device according to claim 8 or claim 9, characterized by a coupling inductance (11) as differentiating encoder (1) which is permeated by the magnetic field of a primary winding (10) through which the gate current (i_G) flows.

13. A device according to claim 12, characterised in that the coupling inductance comprises a two-dimensional structure on a printed circuit board.

**Revendications**

1. Procédé pour identifier l'état bloqué d'un thyristor susceptible de mise à l'état d'ouverture (thyristor GTO) (8), notamment également après une tentative infructueuse de mise à l'état d'ouverture, dans le cas d'un thyristor ayant fait l'objet d'un claquage, et selon lequel, après l'apparition d'un signal de passage à l'état d'ouverture (S), un signal d'état (Z), qui caractérise l'apparition de l'état de blocage, est formé à partir de la dérivée dans le temps du courant de gâchette (di_G/dt), caractérisé par le fait que le signal d'état est déclenché lorsque le signe de la dérivée dans le temps du courant de gâchette s'inverse et que cette dérivée dépasse une valeur limite positive prédéterminée (S_O), qui est choisie supérieure à la valeur positive maximale de la dérivée dans le temps du courant de gâchette, qui apparaît lors de la tentative de passage à l'état d'ouverture d'un thyristor GTO ayant fait l'objet d'un claquage.

2. Procédé suivant la revendication 1, caractérisé par le fait que, lors de l'apparition d'un signal de passage à l'état d'ouverture (S) à la sortie d'un étage d'attaque (9), qui est raccordé à l'électrode de gâchette et à l'électrode de cathode du thyristor (8), il apparaît une tension de commutation négative (U_T), qui déclenche le passage à l'état d'ouverture du thyristor, et que le processus de la formation du signal d'état (Z) est déclenché lorsque cette tension de commutation (U_T) est tombée au-dessous d'un seuil inférieur (S_W) choisi de façon appropriée.

3. Procédé suivant la revendication 2, caractérisé par le fait que le seuil inférieur (S_W) est choisi en fonction des inductances parasites propres à l'étage d'attaque de sorte que, dans le cas d'un fonctionnement correct de l'étage d'attaque (9), la tension de commutation négative (U_T) tombe, de façon sûre, au-dessous de ce seuil au moment de l'apparition du signal du passage à l'état d'ouverture (S).

4. Procédé suivant l'une des revendications précédentes, caractérisé par le fait qu'aucun signal d'état (Z) n'est déclenché tant qu'une durée réglable de temporisation (T_V), qui est déclenchée par le début du processus de formation du signal d'état, n'est pas encore écoulée et/ou après que la dérivée dans le temps du courant de gâchette soit tombée au-dessous d'une valeur limite prédéterminée (S$_U$), au début du passage à l'état d'ouverture.

5. Procédé selon la revendication 4, caractérisé en ce que la valeur limite négative (S$_U$) pouvant être prédéterminée et la durée de temporisation réglable (T$_V$) sont réglées l'une sur l'autre de manière que la dérivée dans le temps du courant de gâchette tombe au-dessous de la valeur limite négative, avant que la durée de temporisation soit écoulée.

6. Procédé suivant l'une des revendications précédentes, caractérisé par le fait que, pour empêcher des déclenchements erronés du signal d'état, l'effet de perturbations de type impulsionnel du courant de gâchette (i$_G$) est éliminé par filtrage.

7. Procédé suivant l'une des revendications précédentes, caractérisé par le fait que la formation du signal d'état (Z) est interrompue simultanément lors de la fin du signal (S) du passage à l'état d'ouverture du thyristor.

8. Dispositif pour former le signal d'état (Z) caractérisant l'état de blocage conformément au procédé selon l'une des revendications 1 ou 4 à 7, caractérisé par

    a) un capteur de mesure différentiateur (1), qui forme la dérivée dans le temps du courant de gâchette (i$_G$),

    b) un déclencheur de Schmitt (3), qui présente des valeurs limites positive et négative de commutation (S$_O$, S$_U$) pouvant être prédéterminées, et fournit, à partir de la dérivée dans le temps du courant de gâchette, un signal binaire (A),

    c) un générateur de signaux (5), qui forme un signal auxiliaire (S$_V$) directement à partir du signal (S) de passage à l'état d'ouverture du thyristor, avec un retard de mise en œuvre égal à une durée de temporisation réglable (E$_V$), et

    d) un circuit logique ET (6), qui combine le signal binaire (A) et le signal auxiliaire (S$_V$) pour former le signal d'état (Z).

9. Dispositif pour former le signal d'état (Z) caractérisant l'état de blocage selon l'une des revendications 1 à 7, caractérisé par

    a) un étage d'attaque (9), qui est commandé par le signal du passage à l'état d'ouverture (S) et alimente le thyristor (8) avec une tension de commutation négative (U$_T$), entre l'électrode de gâchette et l'électrode formant cathode du thyristor,

    b) un capteur de mesure différentiateur (1), qui forme la dérivée dans le temps du courant de gâchette (i$_G$),

    c) un déclencheur de Schmitt (3), qui présente des valeurs limites positive et négative de commutation (S$_O$, S$_U$) pouvant être prédéterminées, et fournit, à partir de la dérivée dans le temps du courant de gâchette, un signal binaire (A),

    d) un générateur de signaux (5), qui produit un signal auxiliaire (S$_V$), avec un retard de mise en œuvre égal à une durée de temporisation réglable (T$_V$), qui est introduite par l'entrée inverseuse d'un comparateur (5a), qui contrôle la tension de commutation (U$_T$) présente à la sortie de l'étage d'attaque (9), par comparaison à un seuil inférieur réglable (S$_W$), et

    e) un circuit logique ET (6), qui combine le signal binaire (A) et le signal auxiliaire (S$_V$) pour fournir le signal d'état (Z).

10. Dispositif suivant l'une des revendications 8 ou 9, caractérisé par un circuit à retard (4) formant élément de filtre, qui supprime des variations transitoires du signal binaire (A) provoquées par des perturbations impulsionnelles du courant de gâchette, et une durée inférieure à une durée de filtrage (T$_G$) pouvant être prédéterminée par le circuit à retard, ce qui permet d'éviter des déclenchements erronés du signal d'état.

11. Dispositif suivant l'une des revendications 8 ou 9, caractérisé par des moyens (2) pour interrompre le signal d'état à la fin du signal (S) du passage à l'état d'ouverture du thyristor, par mise à l'état inactif de l'entrée du déclencheur de Schmitt.

12. Dispositif suivant l'une des revendications 8 ou 9, caractérisé par une inductance de couplage (11) formant capteur de mesure différentiateur (1), qui est traversé par le champ magnétique d'un enroulement primaire (10) parcouru par le courant de gâchette (i$_G$).

13. Dispositif suivant la revendication 12, caractérisé par le fait que l'inductance de couplage est réalisée sous la forme d'une structure bidimensionnelle sur une plaquette à circuits imprimés.

FIG 1

FIG 2

FIG 3

FIG 4

FIG 5

FIG 6

FIG 7

**FIG 8**